# FASCICULE DE BREVET EUROPEEN

(11) **EP 3 514 841 B1**
(45) Date de publication et mention de la délivrance du brevet: **30.12.2020**
(21) Numéro de dépôt: 19160785.2
(22) Date de dépôt: 20.01.2016
(51) Int. Cl.: H01L 33/18, H01L 33/08, H01L 33/24, H01L 33/26

(54) **DISPOSITIF OPTOÉLECTRONIQUE ET SON PROCÉDÉ DE FABRICATION**
OPTOELEKTRONISCHE VORRICHTUNG UND VERFAHREN ZU IHRER HERSTELLUNG
OPTOELECTRONIC DEVICE AND METHOD FOR MANUFACTURING SAME

(30) Priorité: 22.01.2015 FR 1550511
(43) Date de publication de la demande: 24.07.2019
(62) Numéro(s) de document de la (des) demande(s) initiale(s) en application de l'article 76 CBE: 16703590.6 / 3 248 227
(73) Titulaire: Aledia, 38130 Echirolles (FR); Centre National de la Recherche Scientifique, 75794 Paris Cedex 16 (FR)
(72) Inventeur: AMSTATT, Benoît, 38000 GRENOBLE (FR); SCARINGELLA, Sylvia, 38330 MONTBONNOT SAINT MARTIN (FR); ZUNIGA-PEREZ, Jesus, 06410 BIOT (FR)
(74) Mandataire: Cabinet Beaumont

(56) Documents cités:
- US-A1- 2014 077 151
- US-A1- 2014 363 912
- LI H D ET AL: "Interactions between inversion domains and InGaN/GaN multiple quantum wells investigated by transmission electron microscopy", JOURNAL OF CRYSTAL GROWTH, ELSEVIER, AMSTERDAM, NL, vol. 247, no. 1-2, 1 janvier 2003 (2003-01-01), pages 28-34, XP004395061, ISSN: 0022-0248, DOI: 10.1016/S0022-0248(02)01913-9
- LAI YEN-LIN ET AL: "Effects of the material polarity on the green emission properties of InGaN/GaN multiple quantum wells", APPLIED PHYSICS LETTERS, AMERICAN INSTITUTE OF PHYSICS, 2 HUNTINGTON QUADRANGLE, MELVILLE, NY 11747, vol. 89, no. 15, 11 octobre 2006 (2006-10-11), pages 151906-151906, XP012086261, ISSN: 0003-6951, DOI: 10.1063/1.2360247
- David Ross Mcgregor ET AL: "Growth optimization and characterization of reactively sputtered zirconium nitride thin films for III-V buffer layer applications", , 7 November 2002 (2002-11-07), XP055711669, Retrieved from the Internet: URL:https://repository.lib.ncsu.edu/bitstr eam/handle/1840.16/1442/etd.pdf?sequence=1 &isAllowed=y [retrieved on 2020-07-03]

## Description

La présente demande de brevet revendique la priorité de la demande de brevet français FR15/50511.

### Domaine

La présente invention concerne de façon générale les dispositifs optoélectroniques à base de matériaux semiconducteurs et leurs procédés de fabrication.

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

### Exposé de l'art antérieur

On appelle région active d'un dispositif optoélectronique la région depuis laquelle est émise la majorité du rayonnement électromagnétique fourni par le dispositif optoélectronique ou est captée la majorité du rayonnement électromagnétique reçu par le dispositif optoélectronique.

Le dispositif optoélectronique est dit à structure bidimensionnelle lorsque la région active est formée sur une couche semiconductrice plane et le dispositif optoélectronique est dit à structure tridimensionnelle lorsque la région active ou les régions actives sont formées sur des éléments semiconducteurs tridimensionnels, par exemple des microfils ou des nanofils.

Il est connu de réaliser une région active comprenant un puits quantique unique ou des puits quantiques multiples. Un puits quantique unique est réalisé en interposant, entre deux couches d'un premier matériau semiconducteur, par exemple un composé III-V, notamment du GaN, respectivement dopé de type P et N, une couche d'un deuxième matériau semiconducteur, par exemple un alliage du composé III-V ou II-VI et d'un troisième élément dont la bande interdite est différente du premier matériau dopé. Le troisième élément est, par exemple, l'indium (In) et le deuxième matériau semiconducteur peut être l'InGaN. Une structure de puits quantiques multiples comprend un empilement de couches semiconductrices formant une alternance de puits quantiques et de couches barrières.

Un dispositif optoélectronique à structure bidimensionnelle ou tridimensionnelle émet généralement un rayonnement sensiblement monochromatique dont la longueur d'onde dépend des propriétés de la région active, et notamment des premier et deuxième matériaux semiconducteurs.

Il peut être souhaitable de réaliser un dispositif optoélectronique ayant un large spectre de longueurs d'onde d'émission ou de réception. Dans le cas d'un dispositif optoélectronique émettant un rayonnement électromagnétique, il est connu de recouvrir le dispositif optoélectronique d'une couche de matériaux photoluminescents pour convertir au moins une partie du rayonnement émis par la région active du dispositif optoélectronique en un rayonnement à une autre longueur d'onde. Toutefois, l'utilisation de matériaux photoluminescents augmente le coût du dispositif optoélectronique et ne permet pas toujours d'obtenir le spectre d'émission souhaitée.

Il serait toutefois souhaitable de disposer d'un dispositif optoélectronique comprenant au moins deux régions actives distinctes adaptées à émettre ou à capter un rayonnement à au moins deux longueurs d'onde différentes.

Les documents LI H D ET AL: "Interactions between inversion domains and InGaN/GaN multiple quantum wells investigated by transmission electron microscopy",JOURNAL OF CRYSTAL GROWTH, (2003-01-01,XP004395061, DOI: 10.1016/S0022-0248(02)01913-9), US 2014/363912 et US 2014/077151 décrivent des dispositifs optoélectroniques à diodes électroluminescentes.

### Résumé

Ainsi, un objet d'un mode de réalisation est de pallier au moins en partie les inconvénients des procédés de fabrication décrits précédemment.

Un autre objet d'un mode de réalisation est que le dispositif optoélectronique puisse être formé à une échelle industrielle et à bas coût.

Dans la description suivante, seuls les "modes de réalisation" de procédé sont des modes de réalisation de l'invention, ceux se rapportant à un dispositif optoélectronique ne décrivent qu'un exemple de dispositif pouvant être obtenu par un procédé selon l'invention.

Ainsi, un mode de réalisation prévoit un dispositif optoélectronique comprenant des premières et deuxièmes régions actives adaptées à émettre ou capter un rayonnement électromagnétique et comprenant au moins un premier matériau semiconducteur comprenant majoritairement un premier composé choisi parmi les composés III-V, les composés II-VI et leurs mélanges, les premières régions actives ayant une première polarité et les deuxièmes régions actives ayant une deuxième polarité différente de la première polarité.

Selon un mode de réalisation, les premières régions actives sont adaptées à émettre ou capter un premier rayonnement électromagnétique à une première longueur d'onde et les deuxièmes régions actives sont adaptées à émettre ou capter un deuxième rayonnement électromagnétique à une deuxième longueur d'onde différente de la première longueur d'onde.

Selon un mode de réalisation, la première polarité correspond à la polarité de l'élément du groupe III ou II et la deuxième polarité correspond à la polarité de l'élément du groupe V ou VI.

Selon un mode de réalisation, le dispositif comprend :
un substrat ;
des premières portions semiconductrices reposant sur le substrat, en un deuxième matériau semiconducteur comprenant majoritairement le premier composé, et ayant la première polarité, les premières régions actives étant en contact avec les premières portions semiconductrices ; et
des deuxièmes portions semiconductrices reposant sur le substrat, en le deuxième matériau semiconducteur, et ayant la deuxième polarité, les deuxièmes régions actives étant en contact avec les deuxièmes portions semiconductrices.

Selon un mode de réalisation, le premier matériau semiconducteur comprend un élément supplémentaire en plus du premier composé.

Selon un mode de réalisation, le dispositif comprend, en outre :
des troisièmes portions d'un troisième matériau semiconducteur, ayant une troisième polarité et situées entre le substrat et les premières portions semiconductrices, le troisième matériau étant un nitrure, un carbure ou un borure d'un métal de transition de la colonne IV, V ou VI ou une combinaison de ces composés ; et
des quatrièmes portions du troisième matériau semiconducteur, ayant une quatrième polarité différente de la troisième polarité, et situées entre le substrat et les deuxièmes portions semiconductrices.

Selon un mode de réalisation, les premières portions semiconductrices ont la forme de pyramides et les deuxièmes portions semiconductrices comprennent des microfils ou des nanofils.

Un mode de réalisation selon l'invention vise un procédé de fabrication d'un dispositif optoélectronique comprenant la formation de premières et deuxièmes régions actives adaptées à émettre ou capter un rayonnement électromagnétique en au moins un premier matériau semiconducteur comprenant majoritairement un premier composé choisi parmi les composés III-V, les composés II-VI et leurs mélanges, les premières régions actives ayant une première polarité et les deuxièmes régions actives ayant une deuxième polarité différente de la première polarité.

Selon un mode de réalisation, le procédé comprend les étapes suivantes :
former sur un substrat des premières portions semiconductrices d'un deuxième matériau semiconducteur comprenant majoritairement le premier composé et ayant la première polarité et des deuxièmes portions semiconductrices du deuxième matériau semiconducteur et ayant la deuxième polarité ; et
faire croître par épitaxie simultanément les premières régions actives au contact des premières portions semiconductrices et les deuxièmes régions actives au contact des deuxièmes portions semiconductrices.

Le procédé comprend, en outre, les étapes suivantes :
former, sur le substrat, des troisièmes portions d'un troisième matériau semiconducteur et ayant une troisième polarité et des quatrièmes portions du troisième matériau semiconducteur et ayant une quatrième polarité différente de la troisième polarité, le troisième matériau étant un nitrure, un carbure ou un borure d'un métal de transition de la colonne IV, V ou VI ou une combinaison de ces composés ; et
faire croître par épitaxie simultanément les premières portions semiconductrices sur les troisièmes portions et les deuxièmes portions semiconductrices sur les quatrièmes portions.

Selon un mode de réalisation, le procédé comprend, en outre, les étapes suivantes :
former, sur le substrat, une couche du troisième matériau et ayant la quatrième polarité ; et
faire croître par épitaxie une partie des troisièmes portions ayant la troisième polarité au contact de la couche.

Selon un mode de réalisation, les troisièmes portions sont formées par MOCVD à une température inférieure à 1150°C.

Selon un mode de réalisation, le procédé comprend, en outre, l'étape suivante :
faire croître par épitaxie simultanément les quatrièmes portions ayant la quatrième polarité au contact de la couche et le reste des troisièmes portions ayant la troisième polarité.

Selon un mode de réalisation, les quatrièmes portions sont formées par MOCVD à une température supérieure à 1200°C.

Selon un mode de réalisation, le procédé comprend, en outre, les étapes suivantes :
former, sur le substrat, une couche du troisième matériau et ayant la quatrième polarité ;
graver la couche jusqu'au substrat pour délimiter les quatrièmes portions ; et
faire croître par épitaxie les troisièmes portions au contact du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un mode de réalisation d'un dispositif optoélectronique à structure bidimensionnelle à spectre d'émission élargi ;
la figure 2 est une coupe, partielle et schématique, d'un mode de réalisation d'un dispositif optoélectronique à structure tridimensionnelle à spectre d'émission élargi ;
la figure 3 est une vue de dessus, partielle et schématique, du dispositif optoélectronique représenté sur la figure 1 ou 2 ;
les figures 4A à 4E sont des coupes, partielles et schématiques, des structures obtenues à des étapes successives d'un mode de réalisation d'un procédé de fabrication du dispositif optoélectronique de la figure 1 ;
les figures 5A à 5F sont des coupes, partielles et schématiques, des structures obtenues à des étapes successives d'un mode de réalisation d'un procédé de fabrication du dispositif optoélectronique de la figure 2 ;
les figures 6A à 6D sont des coupes, partielles et schématiques, des structures obtenues à des étapes successives d'un autre mode de réalisation d'un procédé de fabrication du dispositif optoélectronique de la figure 2 ;
la figure 7 est une coupe, partielle et schématique, de la structure obtenue à une étape d'un autre mode de réalisation d'un procédé de fabrication du dispositif optoélectronique de la figure 2 ;
les figures 8A à 8D sont des coupes, partielles et schématiques, des structures obtenues à des étapes successives d'un mode de réalisation d'un procédé de fabrication du dispositif optoélectronique de la figure 1 ou 2 ; et
les figures 9A et 9B sont des coupes, partielles et schématiques, des structures obtenues à des étapes successives d'un mode de réalisation d'un procédé de fabrication du dispositif optoélectronique de la figure 1 ou 2.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation et de commande du dispositif optoélectronique sont bien connus et ne sont pas décrits. Dans la suite de la description, sauf indication contraire, les termes "sensiblement", "environ" et "de l'ordre de" signifient "à 10 % près", de préférence à 5 % près.

Dans la suite de la description, le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

La présente demande concerne notamment des dispositifs optoélectroniques à structure tridimensionnelle comprenant des éléments tridimensionnels, par exemple des microfils, des nanofils, des éléments coniques ou des éléments tronconiques. En particulier, un élément conique ou tronconique peut être un élément conique ou tronconique de révolution ou un élément conique ou tronconique pyramidal. Dans la suite de la description, des modes de réalisation sont notamment décrits pour des dispositifs optoélectroniques à structure tridimensionnelle à microfils ou à nanofils. Toutefois, ces modes de réalisation peuvent être mis en oeuvre pour des éléments tridimensionnels autres que des microfils ou des nanofils, par exemple des éléments tridimensionnels coniques ou tronconiques.

Le terme "microfil", "nanofil", "élément conique" ou "élément tronconique" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

Selon un mode de réalisation, le dispositif optoélectronique à structure bidimensionnelle ou tridimensionnelle comprend des régions actives qui sont formées par épitaxie sur des portions semiconductrices d'un même matériau et qui ont des polarités différentes. Les inventeurs ont mis en évidence que les régions actives formées simultanément dans les mêmes conditions de croissance ont des propriétés d'émission ou de réception différentes selon la polarité des portions semiconductrices sur lesquelles elles sont formées. En particulier, des régions actives adaptées à émettre ou à absorber un rayonnement électromagnétique à des longueurs d'onde différentes peuvent être obtenues.

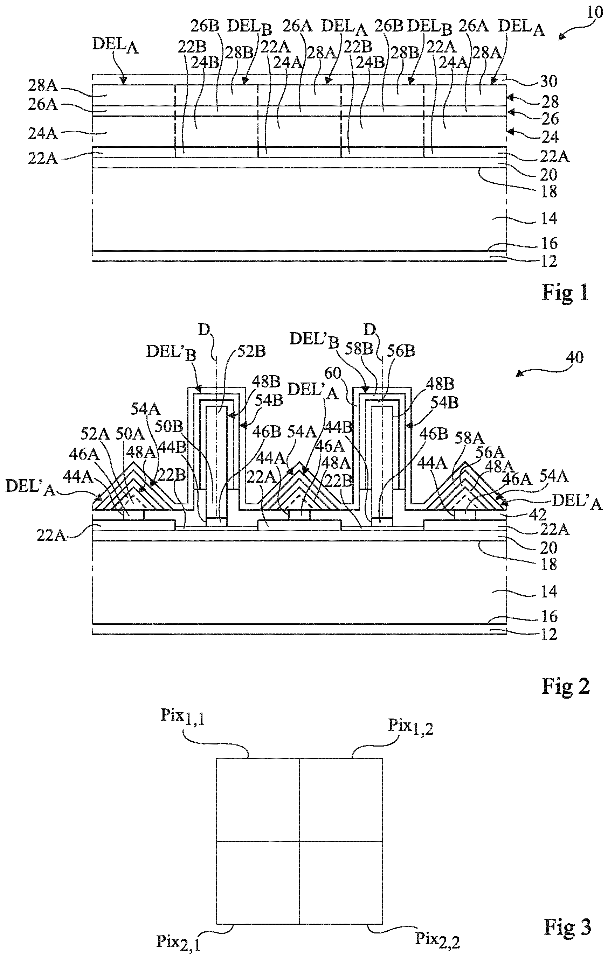

La figure 1 est une coupe, partielle et schématique, d'un mode de réalisation d'un dispositif optoélectronique 10 à structure bidimensionnelle et adapté à l'émission d'un rayonnement électromagnétique.

Le dispositif 10 comprend, du bas vers le haut en figure 1 :
une première électrode de polarisation 12, par exemple métallique ;
un substrat 14 comprenant une première face 16 au contact de l'électrode 12 et une deuxième face 18 opposée à la première face 16 ;
une couche de germination 20 d'un premier matériau semiconducteur avec une première polarité, au contact de la face 18 ;
des premières portions de germination 22A, au contact de la couche 20, du premier matériau semiconducteur avec une deuxième polarité différente de la première polarité ;
des deuxièmes portions de germination 22B, au contact de la couche 20, du premier matériau avec la première polarité, contigües aux premières portions 22A, les portions de germination 22A et 22B ayant, dans le présent mode de réalisation, des surfaces supérieures sensiblement coplanaires ;
une couche semiconductrice 24 d'un deuxième matériau semiconducteur dopé d'un premier type de conductivité recouvrant les première et deuxième portions 22A, 22B et se divisant en premières régions 24A semiconductrices, au contact des premières portions 22A et ayant une première polarité, et en deuxièmes régions semiconductrices 24B, au contact des deuxièmes portions 22B et contiguës aux premières régions semiconductrices 24A et ayant une deuxième polarité différente de la première polarité, les surfaces supérieures des portions conductrices 22A, 24B étant également sensiblement coplanaires ;
une couche active 26 recouvrant la couche semiconductrice 24 et se divisant en premières régions actives 26A au contact des premières régions semiconductrices 24A et en deuxièmes régions actives 26B, contiguës aux premières régions actives 26A et au contact des deuxièmes régions 24B ;
une couche semiconductrice 28 du deuxième matériau semiconducteur dopé d'un deuxième type de conductivité opposé au premier type de conductivité, recouvrant la couche active 26 et se divisant en troisièmes régions semiconductrices 28A, au contact des premières régions actives 26A et ayant une première polarité, et en quatrièmes régions semiconductrices 28B, au contact des deuxièmes régions actives 26B, contiguës aux troisièmes régions semiconductrices 28A et ayant une deuxième polarité ; et
une couche de seconde électrode 30 recouvrant la couche semiconductrice 28.

Selon un autre mode de réalisation, les surfaces supérieures des portions de germination 22A et 22B ne sont pas coplanaires et seules les surfaces supérieures des portions conductrices 22A, 24B sont sensiblement coplanaires.

Chaque empilement comprenant une première région active 26A prise en sandwich entre une première région semiconductrice 24A et une troisième région semiconductrice 28A constitue une première diode électroluminescente DEL_{A}. Chaque empilement comprenant une deuxième région active 26B prise en sandwich entre une deuxième région semiconductrice 24B et une quatrième région semiconductrice 28B constitue une deuxième diode électroluminescente DEL_{B}.

Dans le présent mode de réalisation, les diodes électroluminescentes DEL_{A}, DEL_{B} sont connectées en parallèle. Le dispositif optoélectronique 10 peut comprendre d'une diode électroluminescente DEL_{A} à un millier de diodes électroluminescentes DEL_{A} et d'une diode électroluminescente DEL_{B} à un millier de diodes électroluminescentes DEL_{B}.

La figure 2 est une coupe, partielle et schématique, d'un mode de réalisation d'un dispositif optoélectronique 40 à structure tridimensionnelle à fils tels que décrits précédemment et adapté à l'émission d'un rayonnement électromagnétique.

Le dispositif 40 comprend, comme le dispositif optoélectronique 10 représenté en figure 1, la première électrode 12, le substrat 14, la couche 20, les premières portions 22A et les deuxièmes portions 22B à la différence que les deuxièmes portions 22B peuvent ne pas avoir la même épaisseur que les premières portions 22A.

Le dispositif 40 comprend, en outre, du bas vers le haut en figure 2 :
une région isolante 42 recouvrant les premières portions de germination 22A et les deuxièmes portions de germination 22B et comprenant des ouvertures 44A, 44B, chaque ouverture 44A exposant une partie de l'une des premières portions de germination 22A et chaque ouverture 44B exposant une partie de l'une des deuxièmes portions de germination 22B ;
des premiers germes 46A situés dans les ouvertures 44A au contact des premières portions de germination 22A ;
des deuxièmes germes 46B situés dans les ouvertures 44B au contact des deuxièmes portions de germination 22B ;
des premières portions semiconductrices 48A correspondant à des premiers éléments semiconducteurs tridimensionnels 48A, qui, dans le présent mode de réalisation, correspondent à des pyramides, trois pyramides 48A étant représentées, chaque pyramide 48A comprenant une portion interne 50A, dopée d'un premier type de conductivité, par exemple de type N, en contact avec l'un des premiers germes 46A, et une portion externe 52A, dopée du premier type de conductivité ou non intentionnellement dopée, recouvrant la portion interne 50A, chaque pyramide 48A pouvant, comme cela est représenté en figure 2, reposer sur la région isolante 42, ou pouvant ne s'étendre que sur le premier germe 46A sous-jacent ;
des deuxièmes portions semiconductrices 48B correspondant à des deuxièmes éléments semiconducteurs tridimensionnels 48B, qui, dans le présent mode de réalisation, correspondent à des fils d'axe D, deux fils 48B étant représentés, chaque fil 48B comprenant une portion inférieure 50B, dopée d'un premier type de conductivité, par exemple de type N, en contact avec l'un des deuxièmes germes 46B, et une portion supérieure 52B, dopée du premier type de conductivité ou non intentionnellement dopée, la région isolante 42 pouvant, en outre, recouvrir les parois latérales de la portion inférieure 50B de chaque fil 48B ;
une première coque 54A recouvrant la portion externe 52A de chaque pyramide 48A, chaque première coque 54A comprenant au moins un empilement d'une région ou couche active 56A recouvrant la portion externe 52A de la pyramide 48A et d'une couche semiconductrice 58A d'un second type de conductivité opposé au premier type de conductivité, recouvrant la couche active 56A ;
une deuxième coque 54B recouvrant la portion supérieure 52B de chaque fil 48B, chaque deuxième coque 54B comprenant au moins un empilement d'une couche active 56B recouvrant la portion supérieure 52B du fil 48B et d'une couche semiconductrice 58B d'un second type de conductivité opposé au premier type de conductivité, recouvrant la couche active 56B ;
une couche de seconde électrode 60 recouvrant les couches semiconductrices 58A, 58B des premières et deuxièmes coques 54A, 54B et la région isolante 42.

Pour le dispositif optoélectronique 10, 40, une couche conductrice, non représentée, peut recouvrir la couche d'électrode 60 entre les fils 48B et les pyramides 48A. Une couche d'encapsulation isolante et transparente, non représentée, peut recouvrir la couche d'électrode 60.

L'ensemble formé par chaque pyramide 48A et la coque 54A associée constitue une première diode électroluminescente DEL'_{A}. L'ensemble formé par chaque fil 48B et la coque 54B associée constitue une deuxième diode électroluminescente DEL'_{B}. Le dispositif optoélectronique 40 peut comprendre d'une diode électroluminescente DEL'_{A} à un millier de diodes électroluminescentes DEL'_{A} et d'une diode électroluminescente DEL'_{B} à un millier de diodes électroluminescentes DEL'_{B}. Les diodes électroluminescentes DEL_{A}, DEL_{B}, DEL'_{A}, DEL'_{B} du dispositif optoélectronique 10 ou 40 peuvent être agencées sous la forme d'une matrice de diodes électroluminescentes.

La figure 3 représente, de façon schématique, une matrice de N rangées et de M colonnes de pixels d'affichage Pix_{i,}j où N et M sont des nombres entiers, qui sont égaux chacun à 2 en figure 3, où i est un nombre entier qui varie de 1 à N et j est un nombre entier qui varie de 1 à M. En figure 3, les rangées et les colonnes sont rectilignes. Toutefois, les pixels d'affichage d'une rangée peuvent être disposés en quinconce par rapport aux pixels des rangées adjacentes. Dans le cas du dispositif optoélectronique 10 représenté en figure 1, les pixels d'affichage Pix_{1,1} et Pix_{2,2} peuvent correspondre à des diodes électroluminescentes DEL_{A} et les pixels d'affichage Pix_{1,2} et Pix_{2,1} peuvent correspondre à des diodes électroluminescentes DEL_{B}. Dans le cas du dispositif optoélectronique 40 représenté en figure 2, les pixels d'affichage Pix_{1,1} et Pix_{2,2} peuvent correspondre à des diodes électroluminescentes DEL'_{A} et les pixels d'affichage Pix_{1,2} et Pix_{2,1} peuvent correspondre à des diodes électroluminescentes DEL'_{B}.

Selon un autre mode de réalisation, le dispositif optoélectronique peut comprendre à la fois des diodes électroluminescentes d'un dispositif optoélectronique à structure bidimensionnelle et des diodes électroluminescentes d'un dispositif optoélectronique à structure tridimensionnelle. Selon un autre mode de réalisation, le pixel d'affichage Pix_{1,1} peut correspondre à une diode électroluminescente DEL_{A} du dispositif optoélectronique 10, le pixel d'affichage Pix_{1,2} peut correspondre à une diode électroluminescente DEL'_{A} du dispositif optoélectronique 40, le pixel d'affichage Pix_{2,1} peut correspondre à une diode électroluminescente DEL'_{B} du dispositif optoélectronique 40 et le pixel d'affichage Pix_{2,2} peut correspondre à une diode électroluminescente DEL_{B} du dispositif optoélectronique 10.

A titre de variante, au lieu de pixels d'affichage, les premières et deuxièmes portions de germination 22A, 22B peuvent avoir la forme de bandes. Le dispositif optoélectronique peut comprendre à la fois des diodes électroluminescentes d'un dispositif optoélectronique à structure bidimensionnelle formées sur des premières bandes et des diodes électroluminescentes d'un dispositif optoélectronique à structure tridimensionnelle formées sur des deuxièmes bandes.

Le substrat 14 peut être une structure monobloc ou comprendre un empilement d'une couche, de deux couches ou de plusieurs couches. Le substrat 14 peut être un substrat semiconducteur, par exemple un substrat en silicium, en germanium, en carbure de silicium, en un composé III-V, tel que du GaN ou du GaAs, ou un substrat en ZnO. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator). Le substrat 14 peut être en un matériau isolant, par exemple du saphir, du dioxyde de silicium (SiO₂) ou du verre. Lorsque la structure du substrat 14 ne permet pas la circulation du courant entre les faces 16 et 18, l'électrode 12 peut être réalisée du côté de la face 18 du substrat 14. Le substrat 14 peut être fortement dopé, faiblement dopé ou non dopé.

La couche de germination 20 et les portions de germination 22A, 22B sont en un matériau favorisant la croissance des portions semiconductrices 24A, 24B et des germes 46A, 46B.

Le matériau composant la couche de germination 20 et les portions de germination 22A, 22B est un nitrure, un carbure ou un borure d'un métal de transition de la colonne IV, V ou VI du tableau périodique des éléments ou une combinaison de ces composés. A titre d'exemple, la couche de germination 20 et les portions de germination 22A, 22B peuvent être en nitrure de titane (TiN), en nitrure de tantale (TaN), en nitrure d'hafnium (HfN), en nitrure de niobium (NbN), en nitrure de zirconium (ZrN), en nitrure et carbure de tantale (TaCN). La couche de germination 20 a, par exemple, une épaisseur comprise entre 1 et 300 nanomètres, de préférence comprise entre 10 et 50 nanomètres. Chaque portion de germination 22A, 22B, par exemple, a une épaisseur comprise entre 1 et 500 nanomètres, de préférence comprise entre 10 et 100 nanomètres. Les portions de germination 22A, 22B peuvent avoir une forme générale cylindrique, dont la base a, par exemple, une forme polygonale, notamment triangulaire, rectangulaire, carrée ou hexagonale.

Le matériau composant la couche de germination 20 et les portions de germination 22A, 22B présente une première polarité ou une deuxième polarité. Selon un mode de réalisation, la couche de germination 20 et les portions de germination 22B ont la première polarité et les portions de germination 22A ont la deuxième polarité. A titre d'exemple, dans un mode de réalisation ne faisant pas partie de l'invention, lorsque la couche de germination 20 et les portions de germination 22A, 22B sont en AlN, la couche de germination 20 et les portions de germination 22B peuvent avoir une polarité N et les portions de germination 22A peuvent avoir une polarité Al.

Les portions semiconductrices 24A, 24B, les germes 46A, 46B, les éléments semiconducteurs 48A, 48B et les couches semiconductrices 28, 58A, 58B sont en majorité formés à partir d'au moins un matériau semiconducteur choisi parmi le groupe comprenant les composés III-V et les composés II-VI.

Les portions semiconductrices 24A, 24B, les germes 46A, 46B, les éléments semiconducteurs 48A, 48B et les couches semiconductrices 28, 58A, 58B peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les portions semiconductrices 24A, 24B, les germes 46A, 46B, les éléments semiconducteurs 48A, 48B et les couches semiconductrices 28, 58A, 58B peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les portions semiconductrices 24A, 24B, les éléments semiconducteurs 48A, 48B et les couches semiconductrices 28, 58A, 58B peuvent, en outre, comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La couche semiconductrice 24 du dispositif optoélectronique 10 peut avoir une épaisseur qui varie de 10 nm à 10 µm, de préférence de 100 nm à 2,5 µm.

Lorsque les éléments semiconducteurs tridimensionnels 48A du dispositif optoélectronique 40 correspondent à des pyramides, la hauteur de chaque pyramide peut être comprise entre 100 nm et une centaine de micromètres, de préférence entre 200 nm et 25 µm. Chaque pyramide 48A peut avoir une structure semiconductrice allongée selon un axe sensiblement perpendiculaire à la face 18. La base de chaque pyramide peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et, de préférence, de 1 µm à 5 µm.

Lorsque les éléments semiconducteurs tridimensionnels 48B du dispositif optoélectronique 40 correspondent à des fils, la hauteur du fil 48B peut être comprise entre 250 nm et 50 µm. Chaque fil 48B peut avoir une structure semiconductrice allongée selon un axe D. Les axes D des fils 48B peuvent être sensiblement parallèles. Chaque fil 48B peut avoir une forme générale cylindrique, dont la base a, par exemple, une forme ovale, circulaire ou polygonale, notamment triangulaire, rectangulaire, carrée ou hexagonale. Les axes de deux fils 48B adjacents peuvent être distants de 0,5 µm à 10 µm et, de préférence, de 1,5 µm à 5 µm. A titre d'exemple, les fils 48B peuvent être régulièrement répartis, notamment selon un réseau hexagonal.

Selon un mode de réalisation, la portion inférieure 50B de chaque fil 48B est principalement constituée d'un composé III-N, par exemple du nitrure de gallium, dopé d'un premier type de conductivité, par exemple de type N. Le dopant de type N peut être le silicium. La hauteur de la portion inférieure 50B peut être comprise entre 500 nm et 25 µm.

Selon un mode de réalisation, la portion supérieure 52B de chaque fil 48B est, par exemple, au moins partiellement réalisée dans un composé III-N, par exemple du nitrure de gallium. La portion supérieure 52B peut être dopée du premier type de conductivité, par exemple de type N, ou ne pas être dopée de façon intentionnelle. La hauteur de la portion supérieure 52B peut être comprise entre 500 nm et 25 µm.

Dans le cas d'un fil 48B composé principalement de GaN, la structure cristalline du fil peut être du type wurtzite, le fil s'étendant selon la direction cristallographique c.

La couche active 26, 56A, 56B est la couche depuis laquelle est émise la majorité du rayonnement fourni par le dispositif optoélectronique 10, 40. La couche active 26, 56A, 56B peut comporter des moyens de confinement. A titre d'exemple, la couche active 26, 56A, 56B peut comprendre un puits quantique unique. Elle peut alors comprendre un matériau semiconducteur ayant une bande interdite inférieure à celle du matériau formant les couches semiconductrices 24, 28, les éléments semiconducteurs tridimensionnels 48A, 48B et les couches semiconductrices 58A, 58B. La couche active 26, 56A, 56B peut comprendre des puits quantiques multiples. Elle comprend alors un empilement de couches semiconductrices formant une alternance de puits quantiques et de couches barrières.

La couche semiconductrice 28, 58A, 58B peut comprendre un empilement de plusieurs couches comprenant notamment :
- une couche de blocage d'électrons recouvrant la couche active 26, 56A, 56B ;
- une couche intermédiaire de type de conductivité opposé à la couche semiconductrice 24 ou aux portions semiconductrices 50A, 50B et recouvrant la couche de blocage d'électrons ; et
- une couche de liaison recouvrant la couche intermédiaire et recouverte par l'électrode 30, 60.

La couche de blocage d'électrons peut être formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

La couche intermédiaire, par exemple dopée de type P, peut correspondre à une couche semiconductrice ou à un empilement de couches semiconductrices et permet la formation d'une jonction P-N ou P-I-N, la couche active 26, 56A, 56B étant comprise entre la couche intermédiaire de type P et la portion semiconductrice 24A, 50A, 50B de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 30, 60. A titre d'exemple, la couche de liaison peut être dopée très fortement du type opposé à la portion semiconductrice 24A, 24B, 50A, 50B, jusqu'à dégénérer la ou les couches semiconductrices, par exemple dopée de type P à une concentration supérieure ou égale à 10²⁰ atomes/cm³.

La couche intermédiaire et/ou la couche de liaison peuvent être en majorité formées à partir d'au moins un matériau semiconducteur choisi parmi le groupe comprenant les composés III-V et les composés II-VI.

La région isolante 42 du dispositif optoélectronique 40 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la région isolante 42 est comprise entre 10 nm et 25 µm. La région isolante 42 peut avoir une structure monocouche ou correspondre à un empilement de deux couches ou de plus de deux couches.

L'électrode 30, 60 est adaptée à polariser la couche active 26, 56A, 56B et à laisser passer le rayonnement électromagnétique émis par les diodes électroluminescentes DEL_{A}, DEL_{B}, DEL'_{A}, DEL'_{B}. Le matériau formant l'électrode 30, 60 peut être un matériau transparent et conducteur tel que de l'oxyde d'indium dopé à l'étain (ou ITO, acronyme anglais pour Indium Tin Oxide), de l'oxyde de zinc dopé ou non à l'aluminium ou au gallium, ou du graphène. A titre d'exemple, la couche d'électrode 30, 60 a une épaisseur comprise entre 5 nm et 200 nm, de préférence entre 20 nm et 50 nm.

Lorsqu'une tension est appliquée entre les électrodes 12 et 30, 60, un rayonnement lumineux est émis par la couche active 26, 56A, 56B.

Le procédé de croissance de la couche de germination 20, de la couche semiconductrice 24, des germes 46A, des éléments semiconducteurs tridimensionnels 48A, 48B, des couches actives 26, 56A, 56B et/ou des couches semiconductrices 28, 58A, 58B peut être un procédé du type dépôt chimique en phase vapeur (CVD, acronyme anglais pour Chemical Vapor Déposition) ou dépôt chimique en phase vapeur aux organométalliques (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) ou un procédé de dépôt de couche mince atomique (ALD, acronyme anglais pour Atomic Layer Déposition) peuvent être utilisés. En outre, des procédés de dépôt physique en phase vapeur (PVD, acronyme anglais pour Physical Vapor Déposition) ou de dépôt chimique en phase vapeur peuvent être utilisés, par exemple le dépôt en bain chimique (CBD, sigle anglais pour Chemical Bath Déposition), les procédés hydrothermiques, la pyrolise d'aérosol liquide, l'électrodépôt ou la pulvérisation cathodique.

Le procédé de croissance des portions de germination 22A, 22B peut être un procédé du type CVD, MOCVD, MBE, GSMBE, MOMBE, PAMBE, ALE, HVPE, PVD ou ALD.

A titre d'exemple, dans le cas de la couche semiconductrice 24, des germes 46A, 46B et/ou des éléments semiconducteurs tridimensionnels 48A, 48B, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphoshine (TBT), l'arsine (AsH₃), ou le diméthylhydrazine asymétrique (UDMH). On appelle rapport V/III le rapport entre le flux de gaz du précurseur de l'élément du groupe V et le flux de gaz du précurseur de l'élément du groupe III.

Selon un mode de réalisation de l'invention, dans une phase de croissance de la couche semiconductrice 24 et/ou des éléments semiconducteurs tridimensionnels 48A, 48B du composé III-V, notamment pour la croissance de la portion 50A, 50B, un précurseur d'un élément supplémentaire est ajouté en plus des précurseurs du composé III-V. La présence du précurseur de l'élément supplémentaire conduit à l'incorporation de l'élément supplémentaire dans le composé III-V pour doper ce composé III-V. Dans le cas de la portion inférieure 50B du fil 48B, ceci conduit, en outre, à la formation d'une couche d'un matériau diélectrique principalement constitué de l'élément supplémentaire et de l'élément du groupe V sur les flancs latéraux des cristaux en croissance du composé III-V. L'élément supplémentaire peut être le silicium (Si). Un exemple de précurseur du silicium est le silane (SiH₄). Ceci permet de doper les fils de type N. Ceci peut entraîner, en outre, la formation d'une couche diélectrique de nitrure de silicium SiN, éventuellement sous forme stoechiométrique Si₃N₄, sur les parois latérales du fil. L'épaisseur de la couche diélectrique de Si₃N₄ obtenue est alors généralement inférieure à 10 nm.

Le dispositif optoélectronique 10, 40 est formé de façon que la polarité des portions semiconductrices 24A, 52A soit différente de la polarité des portions semiconductrices 24B, 52B. De ce fait, la polarité des régions actives 26A, 56A est différente de la polarité des régions actives 26B, 56B. La longueur d'onde du rayonnement électromagnétique émis ou capté par le dispositif optoélectronique dépend notamment de la bande interdite du matériau formant le puits quantique ou les puits quantiques. Lorsque le matériau est un alliage du composé III-V ou II-VI et d'un troisième élément, la longueur d'onde du rayonnement émis ou capté dépend notamment du pourcentage atomique du troisième élément, par exemple l'indium. En particulier, plus le pourcentage atomique d'indium est élevé, plus la longueur d'onde est élevée.

Dans le cas où les couches actives sont formées par épitaxie et comprennent un troisième élément, l'incorporation du troisième élément dépend notamment de la polarité de la couche active. Il en résulte que la proportion du troisième élément est différente entre les régions actives 26A, 56A et les régions actives 26B, 56B. Il en résulte que les longueurs d'onde d'émission liées aux régions actives 26A, 56A sont différentes de celles des régions actives 26B, 56B. Le dispositif optoélectronique 10 représenté en figure 1 et le dispositif optoélectronique 40 représenté en figure 2 sont adaptés à émettre un rayonnement lumineux ayant au moins deux longueurs d'onde différentes. On peut ainsi obtenir un dispositif ayant des propriétés d'émission ou de réception large bande. En particulier, le spectre d'émission ou de réception obtenu peut être caractéristique d'une lumière blanche. Par rapport à un dispositif optoélectronique comprenant des microfils ou nanofils émettant de la lumière bleue et une couche comprenant des luminophores absorbant une partie de la lumière bleue et émettant de la lumière jaune, de sorte que le spectre global d'émission du dispositif optoélectronique soit proche de celui de la lumière blanche, le dispositif optoélectronique selon les présents modes de réalisation ne nécessite pas de couche de luminophores pour fournir de la lumière blanche.

En outre, pour le dispositif optoélectronique 40 représenté en figure 2, les couches actives 56A, 56B comprennent une succession de régions ayant des épaisseurs ou des proportions de matériaux différentes. Notamment, dans le cas où la couche active 56A, 56B comprend au moins une couche d'InGaN, la proportion d'indium est modifiée quand le dépôt s'effectue sur des structures à flancs droits ou sur des structures à flancs inclinés. En outre, les épaisseurs des couches d'InGaN et de GaN sont différentes quand ces couches sont formées sur des structures à flancs droits ou sur des structures à flancs inclinés. En effet, la vitesse de croissance, sur des structures à flancs inclinés, des couches formant les puits quantiques ainsi que l'incorporation d'indium dans ces mêmes puits est différente selon les différents diamètres des régions à section droite constante et les différentes inclinaisons des régions à flancs inclinés.

De plus, lorsque le dispositif optoélectronique comprend à la fois des diodes électroluminescentes d'un dispositif optoélectronique à structure bidimensionnelle et des diodes électroluminescentes d'un dispositif optoélectronique à structure tridimensionnelle, un rayonnement lumineux ayant plus de deux longueurs d'onde différentes peut être obtenu. On peut ainsi obtenir un dispositif ayant des propriétés d'émission ou de réception large bande. En particulier, le spectre d'émission ou de réception obtenu peut être caractéristique d'une lumière blanche.

Le procédé de dépôt de la couche de germination 20 est adapté à faire croître la couche de germination 20 selon une première polarité. Les portions de germination 22A sont, au moins en partie, formées par épitaxie sur la couche de germination 20 selon un procédé adapté à changer la polarité des portions de germination 22A par rapport à la couche de germination 20. Selon un mode de réalisation, le procédé est un procédé MOCVD à basse température. Les portions de germination 22B sont, au moins en partie, formées par épitaxie sur la couche de germination 20 selon un procédé adapté à ne pas changer la polarité des portions de germination 22B par rapport à la couche de germination 20. Selon un mode de réalisation, le procédé est un procédé MOCVD à haute température.

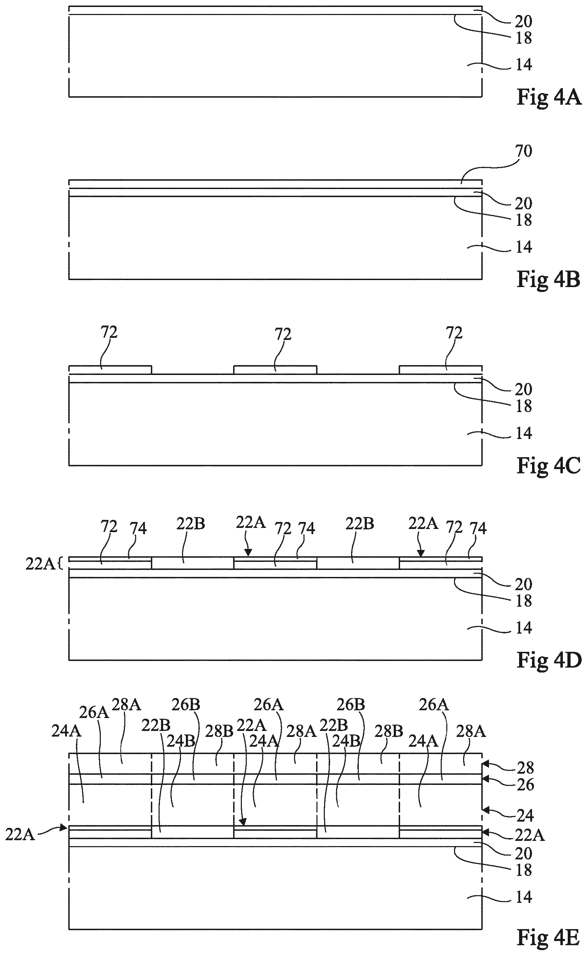

Les figures 4A à 4E sont des coupes, partielles et schématiques, des structures obtenues à des étapes successives d'un mode de réalisation d'un procédé de fabrication du dispositif optoélectronique 10 représenté en figure 1.

La figure 4A représente la structure obtenue après avoir déposé la couche de germination 20 sur la face 18 du substrat 14. A titre d'exemple ne faisant pas partie de l'invention, la couche de germination 20 est en AlN de polarité N. La couche de germination 20 peut être déposée par PVD réactive.

La figure 4B représente la structure obtenue après avoir déposé par épitaxie une couche de germination 70 du même matériau que la couche de germination 20 et ayant une polarité différente de la polarité de la couche de germination 20. Un procédé du type MOCVD peut être mis en oeuvre par injection dans un réacteur MOCVD, de type douchette, de gaz précurseurs de l'aluminium et d'un gaz précurseur de l'azote. A titre d'exemple, on peut utiliser un réacteur MOCVD 3x2", de type douchette, commercialisé par la société AIXTRON. Lorsque, d'après un exemple ne faisant pas partie de l'invention, la couche de germination 20 est en AlN de polarité N, la couche de germination 70 peut être formée par MOCVD à une température inférieure à 1150°C. La couche 70 est alors de polarité Al.

La figure 4C représente la structure obtenue après avoir gravé la couche 70 pour former des portions 72 de polarité Al aux emplacements souhaités pour les portions de germination 22A. Une gravure chimique ou physique, humide ou sèche, peut être mise en oeuvre.

La figure 4D représente la structure obtenue après avoir simultanément formé par épitaxie une portion 74 sur chaque portion 72 et les portions de germination 22B sur les parties de la couche de germination 20 non recouvertes par les portions 72. Les portions 74 sont du même matériau et ont la même polarité que les portions 72. Les portions de germination 22B sont du même matériau et ont la même polarité que la couche de germination 20. L'empilement des portions de germination 72, 74 forme la portion de germination 22A décrite précédemment. Les portions de germination 74 et 22B peuvent être formées par MOCVD à une température supérieure à 1200°C. Dans le présent mode de réalisation, les surfaces supérieures des portions 74 sont sensiblement coplanaires avec les surfaces supérieures des portions de germination 22B. Ceci est rendu possible, dans un mode de réalisation ne faisant pas partie de l'invention, en raison du fait que la vitesse de croissance d'AlN de polarité N et la vitesse de croissance d'AlN de polarité Al sont différentes dans ces conditions de croissance. Selon un autre mode de réalisation, les surfaces supérieures des portions 74 et des portions 22B peuvent ne pas être coplanaires. Les épaisseurs des portions semiconductrices 24A et 24B reposant respectivement sur les portions 74 et 22B peuvent alors être ajustées, notamment par des vitesses de croissance différentes pour le GaN de polarité Ga et le GaN de polarité N, afin que les surfaces supérieures des portions semiconductrices 24A et 24B soient sensiblement coplanaires. Ceci permet la formation d'une couche active 26 à structure bidimensionnelle.

La figure 4E représente la structure obtenue après avoir formé la couche semiconductrice 24, la couche active 26 et la couche semiconductrice 28, par exemple par MOCVD dans des conditions de croissance telles que la polarité des portions semiconductrices 24A, 24B suit celle des portions de germination 22A, 22B sous-jacentes. Dans le mode de réalisation selon lequel la couche semiconductrice 24 est en GaN, les portions 24A de la couche 24 sont de polarité Ga et les portions 24B de la couche 24 sont de polarité N. Dans le mode de réalisation selon lequel la couche active 26 comprend au moins une couche d'InGaN, un précurseur de l'indium peut être prévu dans le réacteur en plus des précurseurs du gallium et de l'azote. Dans des mêmes conditions de croissance, le taux d'incorporation d'indium dans la couche d'InGaN varie en fonction de la polarité Ga ou N de cette couche. La longueur d'onde d'émission de la région 26A de la couche active 26 est donc différente de la longueur d'onde d'émission de la région 26B de la couche active 26.

Les étapes suivantes du procédé comprennent notamment la formation des électrodes 30 et 12.

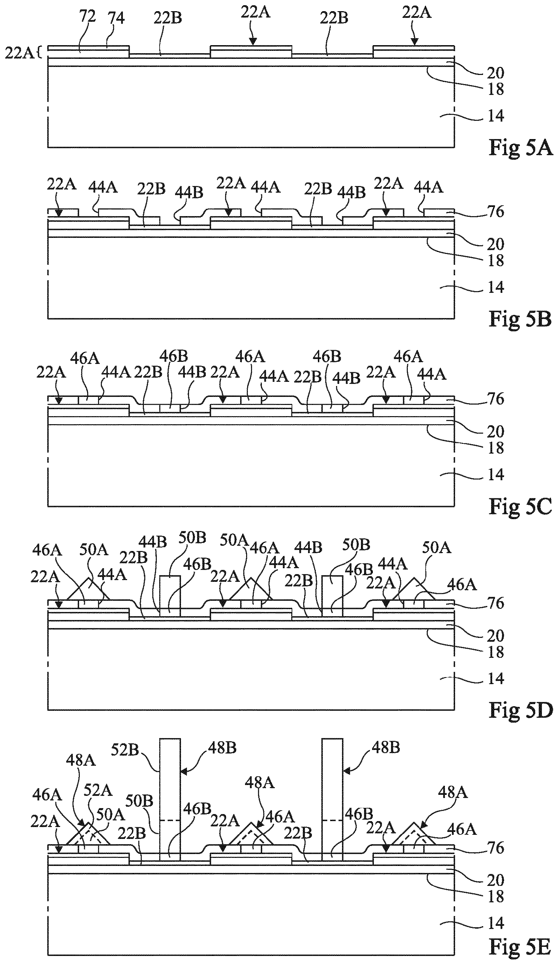

Les figures 5A à 5F sont des coupes, partielles et schématiques, des structures obtenues à des étapes successives d'un mode de réalisation d'un procédé de fabrication du dispositif optoélectronique 40 représenté en figure 2.

Le procédé comprend les étapes décrites précédemment en relation avec les figures 4A à 4D à la différence que l'épaisseur de la portion de germination 22B peut être différente de l'épaisseur de la portion de germination 22A comme cela est illustré en figure 5A.

La figure 5B représente la structure obtenue après avoir formé une couche isolante 76 sur les portions de germination 22A, 22B et après avoir gravé les ouvertures 44A, 44B dans la couche isolante 76 pour exposer des parties des portions de germination 22A, 22B aux emplacements souhaités de formation des germes 46A, 46B.

La figure 5C représente la structure obtenue après la formation des germes 46A, 46B dans les ouvertures 44A, 44B. A titre d'exemple, dans le cas où les germes 46A, 46B sont en GaN, un procédé du type MOCVD peut être mis en oeuvre par injection dans un réacteur MOCVD d'un gaz précurseur du gallium, par exemple le triméthylgallium (TMGa) et d'un gaz précurseur de l'azote, par exemple l'ammoniac (NH₃). Un rapport V/III dans la gamme de 10 à 10000, permet de favoriser la croissance des germes 46A, 46B. La pression dans le réacteur est, par exemple, comprise entre 100 hPa et 800 hPa. La température dans le réacteur est, par exemple, comprise entre 800°C et 1100°C. Les germes 46A, formés sur des portions 22A de polarité Al, ont une polarité Ga. Les germes 46B, formés sur des portions 22B de polarité N, ont une polarité N.

La figure 5D représente la structure obtenue après avoir fait croître les portions internes 50A de pyramides 48A sur les germes 46A et les portions inférieures 50B des fils 48B sur les germes 46B. Selon un mode de réalisation, le rapport V/III est, par exemple, dans la gamme de 10 à 200. La pression dans le réacteur est, par exemple, comprise entre 100 hPa et 800 hPa. La température dans le réacteur est, par exemple, comprise entre 900°C et 1100°C. Dans ces conditions, des fils 48B de polarité N croissent sur les germes 46B de polarité N et des pyramides 48A de polarité Ga croissent sur les germes 46A de polarité Ga.

En outre, un précurseur du silicium, par exemple du silane (SiH₄), est ajouté aux autres gaz précurseurs. La présence de silane parmi les gaz précurseurs entraîne l'incorporation de silicium au sein du composé GaN. On obtient ainsi des portions internes 50A et des portions inférieures 50B dopées de type N. En outre, ceci peut se traduire par la formation d'une couche de nitrure de silicium, non représentée, qui recouvre le pourtour de chaque portion inférieure 50B, à l'exception du sommet au fur et à mesure de la croissance de la portion inférieure 50B. Dans le présent mode de réalisation, les conditions de croissance sont choisies de façon que la couche de nitrure de silicium ne se forme pas sur les portions internes 50A des pyramides 48A.

La figure 5E représente la structure obtenue après avoir fait croître les portions externes 52A des pyramides et les portions supérieures 52B des fils 48B. Selon un mode de réalisation, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion externe 52A et la portion supérieure 52B peuvent être dopées de type N en raison de la diffusion dans ces portions de dopants provenant des portions 50A, 50B ou en raison du dopage résiduel du GaN.

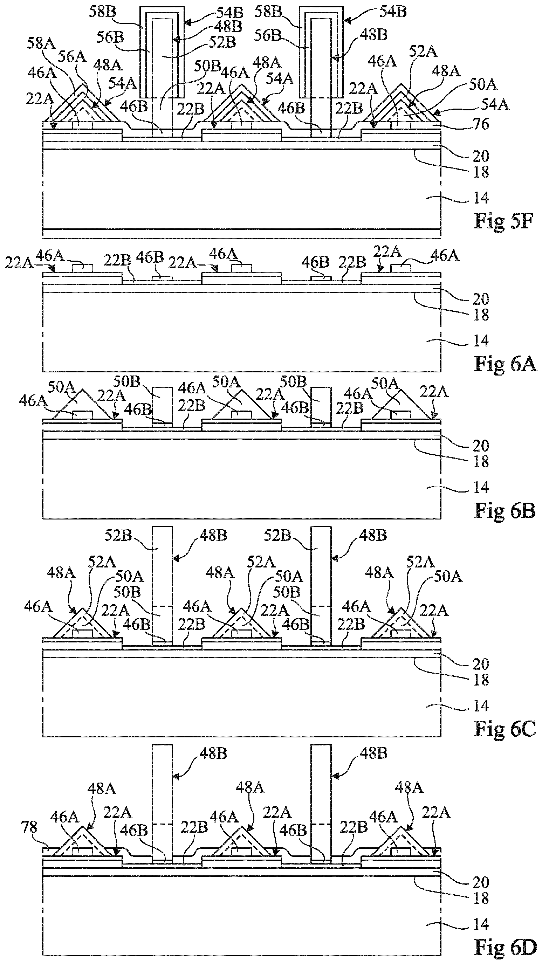

La figure 5F représente la structure obtenue après avoir fait croître simultanément les coques 54A recouvrant les portions externes 52A des pyramides 48A et les coques 54B recouvrant les portions supérieures 52B des fils 48B. Les couches composant la coque 54A, 54B peuvent être formées par épitaxie par MOCVD. Compte tenu de la présence possible de la couche de nitrure de silicium recouvrant le pourtour de la portion inférieure 50B de chaque fil 48B, le dépôt des couches composant la coque 54B ne se produit que sur la portion supérieure 52B de chaque fil 48B. D'autres procédés peuvent être utilisés pour permettre la croissance des puits tout au long des fils en déposant une couche à basse température.

Dans le mode de réalisation selon lequel chaque couche active 56A, 56B comprend une ou plus d'une couche d'InGaN, un précurseur de l'indium peut être prévu dans le réacteur en plus des précurseurs du gallium et de l'azote. Dans des mêmes conditions de croissance, le taux d'incorporation d'indium dans la couche d'InGaN varie en fonction de la polarité Ga ou N de cette couche et selon l'orientation cristallographique de la surface sur laquelle est formée la couche active 56A, 56B.

Les étapes suivantes du procédé comprennent notamment la formation des électrodes 60 et 12.

Les figures 6A à 6D sont des coupes, partielles et schématiques, des structures obtenues à des étapes successives d'un autre mode de réalisation d'un procédé de fabrication d'un dispositif optoélectronique ayant la même structure que le dispositif optoélectronique 40 représenté en figure 2 à la différence que les germes 46A, 46B ne sont pas formés dans des ouvertures d'une couche isolante.

Le procédé comprend les étapes décrites précédemment en relation avec les figures 4A à 4D à la différence que l'épaisseur de la portion de germination 22B peut être différente de l'épaisseur de la portion de germination 22A.

La figure 6A représente la structure obtenue après la formation des germes 46A, 46B sur les portions de germination 22A et 22B. Le nombre de germes 46A, 46B qui peuvent se former sur les portions de germination 22A et 22B dépend des dimensions des portions de germination 22A et 22B. De préférence, les dimensions des portions de germination 22A et 22B peuvent être suffisamment réduites pour favoriser la croissance d'un seul germe 46A, 46B sur chaque portion de germination 22A et 22B. A titre d'exemple, dans le cas où les germes 46A, 46B sont en GaN, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport V/III dans la gamme de 10 à 10000, permet de favoriser la croissance des germes 46A, 46B. La pression dans le réacteur est, par exemple, comprise entre 100 hPa et 800 hPa. La température dans le réacteur est, par exemple, comprise entre 800°C et 1100°C.

La figure 6B représente la structure obtenue après avoir fait croître les portions internes 50A des pyramides 48A et les portions inférieures 50B des fils 48B sur les germes 46A comme cela a été décrit précédemment en relation avec la figure 5D.

La figure 6C représente la structure obtenue après avoir fait croître les portions externes 52A des pyramides 48A et les portions supérieures 52B des fils 48B comme cela a été décrit précédemment en relation avec la figure 5E.

La figure 6D représente la structure obtenue après avoir déposé une couche isolante 78 sur l'ensemble de la structure représenté en figure 6C et après avoir gravé la couche isolante 78 pour ne conserver la couche 78 qu'autour de la base des pyramides 48A et des pieds des fils 48B.

Les étapes suivantes du procédé comprennent notamment la croissance des coques 54A, 54B comme cela a été décrit précédemment en relation avec la figure 5F et la formation des électrodes 60 et 12.

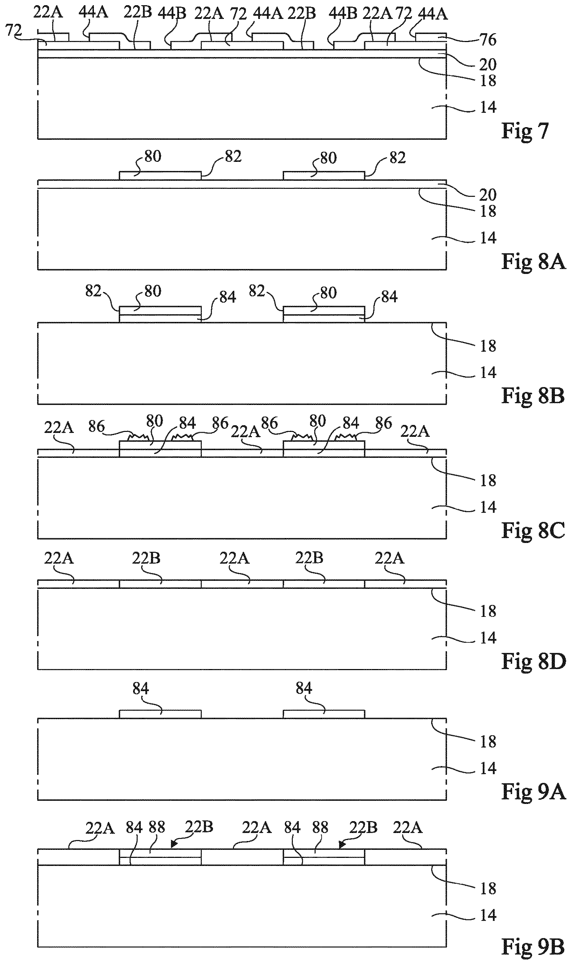

La figure 7 est une coupe, partielle et schématique, de la structure obtenue à une étape d'un autre mode de réalisation d'un procédé de fabrication d'un dispositif optoélectronique ayant la même structure que le dispositif optoélectronique 40 représenté en figure 2. Le procédé selon le présent mode de réalisation est identique au mode de réalisation décrit précédemment en relation avec les figures 5A à 5F à la différence que l'étape de croissance des portions 74 et 22B par épitaxie, décrite précédemment en relation avec la figure 5A, n'est pas présente et que la couche isolante 76 est formée directement sur les portions 72 et sur la couche 20. Dans ce mode de réalisation, les portions de germination 22B correspondent alors aux parties de la couche 20 non recouvertes par les portions 72 et les portions de germination 22A correspondent aux portions 72. De façon avantageuse, le présent mode de réalisation comprend une étape de croissance par épitaxie de moins que le mode de réalisation décrit précédemment en relation avec les figures 5A à 5F. De façon analogue, le procédé de fabrication selon le mode de réalisation décrit précédemment en relation avec les figures 6A et 6B peut être mis en oeuvre en formant directement les germes 46A sur les portions 72 et les germes 46B sur la couche de germination 20.

Les figures 8A à 8D sont des coupes, partielles et schématiques, des structures obtenues à des étapes successives d'un autre mode de réalisation d'un procédé de fabrication du dispositif optoélectronique 10 représenté en figure 1 ou du dispositif optoélectronique 40 représenté en figure 2. Le procédé comprend l'étape décrite précédemment en relation avec la figure 4A.

La figure 8A représente la structure obtenue après les étapes suivantes :
dépôt d'une couche isolante 80 sur la couche 20 ; et
gravure d'ouvertures 82 dans la couche isolante 80 pour exposer des parties de la couche de germination 20 aux emplacements souhaités de formation des portions de germination 22B.

La figure 8B représente la structure obtenue après la gravure de la couche 20 au travers des ouvertures 82 jusqu'au substrat 14 pour délimiter des portions de germination 84 dans la couche 20.

La figure 8C représente la structure obtenue après une étape de croissance par épitaxie qui a entraîné la formation de portions de germination 22A sur les parties du substrat 14 non recouvertes par les portions 84. Les conditions de croissance peuvent être les mêmes que celles décrites précédemment en relation avec la figure 4D. Les inventeurs ont mis en évidence que la polarité des portions 22A qui croissent sur le substrat 14 était opposée à celle des portions 84. Dans le cas de la réalisation d'un dispositif optoélectronique 10 à structure bidimensionnelle, la croissance des portions 22A est poursuivie jusqu'à ce que les surfaces supérieures des portions 22A soient sensiblement coplanaires avec les surfaces supérieures des portions de germination 84. De préférence, le matériau composant la couche isolante 80 ne favorise pas la croissance du matériau composant les portions de germination 22A. Toutefois, certains germes 86 peuvent néanmoins se former sur la couche 80.

La figure 8D représente la structure obtenue après une étape de gravure de la couche isolante 80 de façon à exposer les portions de germination 84. Les portions de germination 84 correspondent alors aux portions de germination 22B décrites précédemment.

Les étapes suivantes du procédé peuvent comprendre les étapes décrites précédemment en relation avec la figure 4E dans le cas de la formation d'un dispositif optoélectronique à structure bidimensionnelle, ou les étapes décrites précédemment en relation avec les figures 5B à 5F ou en relation avec les figures 6A à 6D dans le cas de la formation d'un dispositif optoélectronique à structure tridimensionnelle.

Les figures 9A et 9B sont des coupes, partielles et schématiques, des structures obtenues à des étapes successives d'un autre mode de réalisation d'un procédé de fabrication du dispositif optoélectronique 10 représenté en figure 1 ou du dispositif optoélectronique 40 représenté en figure 2. Le procédé comprend les étapes décrites précédemment en relation avec les figures 8A et 8B.

La figure 9A représente la structure obtenue après le retrait de la couche isolante 80 pour exposer les portions de germination 84.

La figure 9B représente la structure obtenue après une étape de croissance par épitaxie qui a entraîné la formation de portions de germination 22A sur les parties du substrat 14 non recouvertes par les portions 22B et la formation de portions de germination 88 sur les portions 84. Les conditions de croissance peuvent être les mêmes que celles décrites précédemment en relation avec la figure 4D. Les inventeurs ont mis en évidence que la polarité des portions 22A qui croissent sur le substrat 14 était opposée à celle des portions 84 alors que la polarité des portions 88 qui croissent sur les portions 84 ont la même polarité que les portions 84. L'ensemble formé par la portion 88 et la portion 84 sous-jacente constitue alors la portion de germination 22B. Ceci est rendu possible, dans un mode de réalisation ne faisant pas partie de l'invention, en raison du fait que la vitesse de croissance d'AlN de polarité N et la vitesse de croissance d'AlN de polarité Al peuvent être rendues différentes selon les conditions de croissance.

Un mode de réalisation d'un procédé de fabrication d'un dispositif optoélectronique comprenant des diodes électroluminescentes DEL_{A}, DEL_{B} et des diodes électroluminescentes DEL'_{A}, DEL'_{B} peut comporter les étapes de formation des éléments semiconducteurs tridimensionnels 48A, 48B avant ou après les étapes de formation des portions semiconductrices 24A, 24B. Le procédé comprend, en outre, une étape de dépôt d'une couche isolante sur les flancs latéraux des portions semiconductrices 24A, 24B qui correspondent alors à des blocs distincts. Les couches actives 56A, 56B, 26A, 26B peuvent alors être formées simultanément et les couches semiconductrices 58A, 58B, 28A, 28B peuvent être formées simultanément.

Des modes de réalisation particuliers ont été décrits. Diverses variantes et modifications apparaîtront à l'homme de l'art. En particulier, le rapport entre le nombre de diodes électroluminescentes DEL_{A}, DEL'_{A} et le nombre de diodes électroluminescentes DEL_{B}, DEL'_{B} est choisi en fonction du spectre d'émission recherché du dispositif optoélectronique 10, 40. De même, la densité des pyramides ou des fils peut être choisie et modifiée de manière à obtenir différentes concentrations en In des couches actives et ainsi obtenir des longueurs d'onde supplémentaires, qui permettent entre autre de réaliser du blanc.

## Revendications

1. Procédé de fabrication d'un dispositif optoélectronique (10) comprenant la formation de premières et deuxièmes régions actives (26A, 26B ; 56A, 56B) adaptées à émettre ou capter un rayonnement électromagnétique en au moins un premier matériau semiconducteur comprenant majoritairement un premier composé choisi parmi les composés III-V, les composés II-VI et leurs mélanges, les premières régions actives (26A ; 56A) ayant une première polarité et les deuxièmes régions actives (26B ; 56B) ayant une deuxième polarité différente de la première polarité,
dans lequel le procédé comprend les étapes suivantes :
former, sur un substrat (14), des troisièmes portions (22A) d'un troisième matériau semiconducteur et ayant une troisième polarité et des quatrièmes portions (22B) du troisième matériau semiconducteur et ayant une quatrième polarité différente de la troisième polarité, le troisième matériau étant un nitrure, un carbure ou un borure d'un métal de transition de la colonne IV, V ou VI ou une combinaison de ces composés ;
former sur les troisièmes portions (22A), des premières portions semiconductrices (24A ; 46A, 48A) d'un deuxième matériau semiconducteur comprenant majoritairement le premier composé et ayant la première polarité et, sur les quatrièmes portions (22B), des deuxièmes portions semiconductrices (24B ; 46B, 48B) du deuxième matériau semiconducteur et ayant la deuxième polarité ; et
faire croître par épitaxie simultanément les premières régions actives (26A ; 56A) au contact des premières portions semiconductrices (24A ; 46A, 48A) et les deuxièmes régions actives (26B ; 56B) au contact des deuxièmes portions semiconductrices (24B ; 46B, 48B).

2. Procédé selon la revendication 1, comprenant, en outre, les étapes suivantes :
former, sur le substrat (14), une couche (70) du troisième matériau et ayant la quatrième polarité ; et
faire croître par épitaxie une partie des troisièmes portions (22A) ayant la troisième polarité au contact de la couche (70) .

3. Procédé selon la revendication 2, dans lequel les troisièmes portions (22A) sont formées par MOCVD à une température inférieure à 1150°C.

4. Procédé selon la revendication 2 ou 3, comprenant, en outre, l'étape suivante :
faire croître par épitaxie simultanément les quatrièmes portions (22B) ayant la quatrième polarité au contact de la couche (70) et le reste des troisièmes portions (22A) ayant la troisième polarité.

5. Procédé selon la revendication 4, dans lequel les quatrièmes portions (22A) sont formées par MOCVD à une température supérieure à 1200°C.

6. Procédé selon la revendication 1, comprenant, en outre, les étapes suivantes :
former, sur le substrat (14), une couche (70) du troisième matériau et ayant la quatrième polarité ;
graver la couche jusqu'au substrat pour délimiter les quatrièmes portions (22B) ; et
faire croître par épitaxie les troisièmes portions (22A) au contact du substrat (14).

7. Procédé selon l'une quelconque des revendications 1 à 6, dans lequel les premières régions actives (26A ; 56A) sont adaptées à émettre ou capter un premier rayonnement électromagnétique à une première longueur d'onde et dans lequel les deuxièmes régions actives (26B ; 56B) sont adaptées à émettre ou capter un deuxième rayonnement électromagnétique à une deuxième longueur d'onde différente de la première longueur d'onde.

8. Procédé selon l'une quelconque des revendications 1 à 7, dans lequel la première polarité correspond à la polarité de l'élément du groupe III ou II et dans lequel la deuxième polarité correspond à la polarité de l'élément du groupe V ou VI.

9. Procédé selon l'une quelconque des revendications 1 à 8, dans lequel le premier matériau semiconducteur comprend un élément supplémentaire en plus du premier composé.

10. Procédé selon l'une quelconque des revendications 1 à 9, dans lequel les premières portions semiconductrices (46A, 48A) ont la forme de pyramides et dans lequel les deuxièmes portions semiconductrices (46B, 48B) comprennent des microfils ou des nanofils.

## Patentansprüche

1. Verfahren zur Herstellung eines optoelektronischen Bauelements (10), aufweisend das Ausbilden erster und zweiter aktiver Bereiche (26A, 26B; 56A, 56B), die in der Lage sind eine elektromagnetische Strahlung auszusenden oder zu empfangen und aus mindestens einem ersten Halbleitermaterial hergestellt sind, das hauptsächlich eine erste Verbindung aufweist, die aus III-V-Verbindungen, II-VI-Verbindungen und Mischungen davon ausgewählt ist, wobei die ersten aktiven Bereiche (26A; 56A) eine erste Polarität und die zweiten aktiven Bereiche (26B; 56B) eine zweite Polarität aufweisen, die sich von der ersten Polarität unterscheidet,
wobei das Verfahren die folgenden Schritte aufweist:
Ausbilden, auf einem Substrat (14), von dritten Abschnitten (22A) aus einem dritten Halbleitermaterial und mit einer dritten Polarität und von vierten Abschnitten (22B) aus dem dritten Halbleitermaterial und mit einer vierten Polarität, die sich von der dritten Polarität unterscheidet, wobei das dritte Material ein Nitrid, ein Carbid oder ein Borid eines Übergangsmetalls der Gruppe IV, V oder VI oder eine Kombination dieser Verbindungen ist;
Ausbilden auf den dritten Abschnitten (22A) erster Halbleiterabschnitte (24A; 46A, 48A) aus einem zweiten Halbleitermaterial, das hauptsächlich die erste Verbindung und die erste Polarität aufweist, und auf den vierten Abschnitten (22B) zweiter Halbleiterabschnitte (24B; 46B, 48B) aus dem zweiten Halbleitermaterial, mit der zweiten Polarität; und
Wachsen, durch gleichzeitige Epitaxie, der ersten aktiven Bereiche (26A; 56A) in Kontakt mit den ersten Halbleiterabschnitten (24A; 46A, 48A) und der zweiten aktiven Bereiche (26B; 56B) in Kontakt mit den zweiten Halbleiterabschnitten (24B; 46B, 48B).

2. Verfahren nach Anspruch 1, das ferner die folgenden Schritte aufweist:
Ausbilden, auf dem Substrat (14), einer Schicht (70) aus dem dritten Material und mit der vierten Polarität; und
Wachsen, durch Epitaxie, eines Teils der dritten Abschnitte (22A) mit der dritten Polarität in Kontakt mit der Schicht (70).

3. Verfahren nach Anspruch 2, wobei die dritten Abschnitte (22A) durch MOCVD bei einer Temperatur von weniger als 1.150°C ausgebildet werden.

4. Verfahren nach Anspruch 2 oder 3, das weiterhin den folgenden Schritt aufweist:
gleichzeitiges Wachsen, durch Epitaxie, der vierten Abschnitte (22B) mit der vierten Polarität in Kontakt mit der Schicht (70) und des Rests der dritten Abschnitte (22A) mit der dritten Polarität.

5. Verfahren nach Anspruch 4, wobei die vierten Abschnitte (22A) durch MOCVD bei einer Temperatur von mehr als 1.200°C gebildet werden.

6. Verfahren nach Anspruch 1, das ferner die folgenden Schritte aufweist:
Ausbilden, auf dem Substrat (14), einer Schicht (70) aus dem dritten Material und mit der vierten Polarität;
Ätzen der Schicht bis zum Substrat, um die vierten Abschnitte (22B) abzugrenzen; und
Wachsen, durch Epitaxie, der dritten Abschnitte (22A) in Kontakt mit dem Substrat (14).

7. Verfahren nach einem der Ansprüche 1 bis 6, wobei die ersten aktiven Bereiche (26A; 56A) in der Lage sind, eine erste elektromagnetische Strahlung mit einer ersten Wellenlänge auszusenden oder zu empfangen, und wobei die zweiten aktiven Bereiche (26B; 56B) in der Lage sind, eine zweite elektromagnetische Strahlung mit einer zweiten Wellenlänge, die sich von der ersten Wellenlänge unterscheidet, auszusenden oder zu empfangen.

8. Verfahren nach einem der Ansprüche 1 bis 7, wobei die erste Polarität der Polarität des Gruppe-III- oder -II-Elements entspricht und wobei die zweite Polarität der Polarität des Gruppe-V- oder -VI-Elements entspricht.

9. Verfahren nach einem der Ansprüche 1 bis 8, wobei das erste Halbleitermaterial zusätzlich zu der ersten Verbindung ein weiteres Element aufweist.

10. Verfahren nach einem der Ansprüche 1 bis 9, wobei die ersten Halbleiterabschnitte (46A, 48A) die Form von Pyramiden haben und wobei die zweiten Halbleiterabschnitte (46B, 48B) Mikrodrähte oder Nanodrähte aufweisen.

## Claims

1. A method of manufacturing an optoelectronic device (10) comprising forming first and second active regions (26A, 26B; 56A, 56B) capable of emitting or receiving an electromagnetic radiation made of at least one first semiconductor material mainly comprising a first compound selected from III-V compounds, II-VI compounds, and mixtures thereof, the first active regions (26A; 56A) having a first polarity and the second active regions (26B; 56B) having a second polarity different from the first polarity,
wherein the method comprises the steps of:
forming, on a substrate (14), third portions (22A) of a third semiconductor material and having a third polarity and fourth portions (22B) of the third semiconductor material and having a fourth polarity different from the third polarity, the third material being a nitride, a carbide, or a boride of a transition metal of column IV, V, or VI, or a combination of these compounds;
forming on the third portions (22A), first semiconductor portions (24A; 46A, 48A) of a second semiconductor material mainly comprising the first compound and having the first polarity and, on the fourth portions (22B), second semiconductor portions (24B; 46B, 48B) of the second semiconductor material and having the second polarity; and
growing by simultaneous epitaxy the first active regions (26A; 56A) in contact with the first semiconductor portions (24A; 46A, 48A) and the second active regions (26B; 56B) in contact with the second semiconductor portions (24B; 46B, 48B).

2. The method of claim 1, further comprising the steps of:
forming, on the substrate (14), a layer (70) of the third material and having the fourth polarity; and
growing by epitaxy a portion of the third portions (22A) having the third polarity in contact with the layer (70).

3. The method of claim 2, wherein the third portions (22A) are formed by MOCVD at a temperature lower than 1,150°C.

4. The method of claim 2 or 3, further comprising the step of:
growing by epitaxy simultaneously the fourth portions (22B) having the fourth polarity in contact with the layer (70) and the rest of the third portions (22A) having the third polarity.

5. The method of claim 4, wherein the fourth portions (22A) are formed by MOCVD at a temperature higher than 1,200°C.

6. The method of claim 1, further comprising the steps of:
forming, on the substrate (14), a layer (70) of the third material and having the fourth polarity;
etching the layer all the way to the substrate to delimit the fourth portions (22B); and
growing by epitaxy the third portions (22A) in contact with the substrate (14).

7. The method of any of claims 1 to 6, wherein the first active regions (26A; 56A) are capable of emitting or of receiving a first electromagnetic radiation at a first wavelength and wherein the second active regions (26B; 56B) are capable of emitting or of receiving a second electromagnetic radiation at a second wavelength different from the first wavelength.

8. The method of any of claims 1 to 7, wherein the first polarity corresponds to the polarity of the group-III or -II element and wherein the second polarity corresponds to the polarity of the group-V or -VI element.

9. The method of any of claims 1 to 8, wherein the first semiconductor material comprises a further element in addition to the first compound.

10. The method of any of claims 1 to 9, wherein the first semiconductor portions (46A, 48A) have the shape of pyramids and wherein the second semiconductor portions (46B, 48B) comprise microwires or nanowires.
